# EUROPEAN PATENT APPLICATION

(11) **EP 4 783 471 A1**
(43) Date of publication of application: **29.07.2026**
(21) Application number: 24886412.6
(22) Date of filing: 19.09.2024
(51) Int. Cl.: H04B 1/401, H03F 1/02, H03F 1/30, H03F 3/189, H04W 88/06, H04B 1/04

(54) **ELECTRONIC DEVICE AND COMMUNICATION PERFORMING METHOD USING SAME**

(30) Priority: 01.11.2023 KR 20230149471; 08.12.2023 KR 20230177944
(71) Applicant: Samsung Electronics Co., Ltd., Suwon-si, Gyeonggi-do 16677 (KR)
(72) Inventor: KIM, Kwangho, Suwon-si, Gyeonggi-do 16677 (KR); KIM, Heekon, Suwon-si, Gyeonggi-do 16677 (KR); SON, Jisu, Suwon-si, Gyeonggi-do 16677 (KR); JOO, Youngchan, Suwon-si, Gyeonggi-do 16677 (KR); CHOI, Wonjin, Suwon-si, Gyeonggi-do 16677 (KR); KIM, Yongwoon, Suwon-si, Gyeonggi-do 16677 (KR); PARK, Eunsoo, Suwon-si, Gyeonggi-do 16677 (KR)
(74) Representative: Gulde & Partner
(86) International application number: PCT/KR2024/096212
(87) International publication number: WO 2025/095742

(57) **Abstract**

According to one embodiment, an electronic device may comprise: a temperature sensor; a plurality of power amplifiers; a memory; and a processor operatively connected to the temperature sensor, the plurality of power amplifiers and the memory. The processor can: use a first power amplifier from among the plurality of power amplifiers so as to perform first communication; use a second power amplifier from among the plurality of power amplifiers so as to perform second communication; use the temperature sensor so as to check the temperature of the electronic device while the first communication and the second communication are performed; respond to a situation in which the temperature of the electronic device exceeds a set first threshold temperature, so as to terminate the second communication; and change a power amplifier that is to perform the first communication. Other various embodiments are possible.

## Description

### [Technical Field]

Embodiments of the disclosure relate to an electronic device and a communication performing method using the same.

### [Background Art]

An electronic device supporting wireless communication may transmit or receive a communication signal, based on a configured communication frequency band, in order to transmit/receive data to/from a base station. Recently, an electronic device may support not only a standalone (SA) communication based on one communication scheme, but also a non-standalone (NSA) communication based on multiple communication schemes. For example, the electronic device may support a complex communication scheme, such as E-UTRA NR dual connectivity (ENDC) communication and NR E-UTRA dual connectivity (NEDC) communication, based on multiple antennas and multiple power amplifiers (PAs). For example, ENDC communication may be a communication scheme that, based on LTE communication (e.g., 4G communication, LTE anchor) configured as a primary communication scheme, uses both LTE communication and NR communication (e.g., 5G communication) to increase the data transmission speed. In ENDC communication, an electronic device may be connected to both an LTE base station and an NR base station at the same time, and the LTE base station may be configured as a master base station. For example, NEDC communication may be a communication scheme that, based on the NR communication (e.g., 5G communication, NR anchor) configured as a primary communication scheme, uses both NR communication and LTE communication to increases the data transmission speed. In NEDC communication, an electronic device may be connected to both an NR base station and an LTE base station at the same time, and the NR base station may be configured as a master base station.

According to an embodiment, the speed of communication (e.g., data communication) based on a complex communication scheme (e.g., ENDC or NEDC) may be relatively faster than the speed of communication based on a single communication scheme.

The above-described information may be provided as related art for the purpose of helping to understand the disclosure. None of the above-described contents are intended to suggest or assert that the contents are prior art applicable to the disclosure.

### [Disclosure of Invention]

### [Technical Problem]

In a situation where multiple communication frequency bands are used together (e.g., EN-DC, NE-DC), when communication based on EN-DC is maintained, the internal temperature of an electronic device may rise, and may exceed a predetermined limit temperature. For example, when the internal temperature of the electronic device exceeds the limit temperature, the electronic device may perform an LTE fallback function to switch from the EN-DC communication scheme to an LTE communication scheme. For example, upon switching from the EN-DC communication scheme to the LTE communication scheme, communication performance may be relatively degraded, and the internal temperature of the electronic device may decrease. When the internal temperature of the electronic device is lower than a recovery temperature, the electronic device may switch back from the LTE communication scheme to the EN-DC communication scheme. Upon switching from the LTE communication scheme to the EN-DC communication scheme, communication performance may be improved compared to the LTE communication scheme, and the internal temperature of the electronic device may rise more rapidly than in the LTE communication scheme.

According to an embodiment, in a situation where the internal temperature of the electronic device exceeds the limit temperature, the electronic device performs an LTE fallback function to switch from the EN-DC communication scheme to the LTE communication scheme. The electronic device that has switched to the LTE communication scheme may have a slower temperature decrease rate, and thus the LTE communication scheme may be maintained for a prolonged time. The phenomenon of degraded communication speed may be maintained for a long time in the user's perception, and the user's satisfaction with the communication speed may decrease.

The technical problems to be solved in the disclosure is not limited to the above-described technical problems, and other technical problems which are not mentioned may be clearly understood by those skilled in the art to which the disclosure pertains from the following descriptions.

### [Solution to Problem]

According to an embodiment, an electronic device may include a temperature sensor, multiple power amplifiers, a memory, and a processor operatively connected to the temperature sensor, the multiple power amplifiers, and the memory. According to an embodiment, the processor may be configured to perform first communication (e.g., LTE communication) by using a first power amplifier among the multiple power amplifiers. The processor may be configured to perform second communication (e.g., NR communication) by using a second power amplifier among the multiple power amplifiers. The processor may be configured to identify a temperature of the electronic device by using the temperature sensor while performing the first communication and the second communication. The processor may be configured to release a connection of the second communication in response to a situation in which the temperature of the electronic device exceeds a first predetermined threshold temperature (e.g., a limit temperature). The processor may be configured to switch a power amplifier that is to perform the first communication.

According to an embodiment, a method for performing communication by an electronic device may include: performing first communication by using a first power amplifier among multiple power amplifiers; performing second communication by using a second power amplifier among the multiple power amplifiers; identifying a temperature of the electronic device 101 by using a temperature sensor while performing the first communication and the second communication; releasing the second communication in response to a situation in which the temperature of the electronic device exceeds a first predetermined threshold temperature; and switching a power amplifier that is to perform the first communication.

According to an embodiment, a non-transitory computer-readable storage medium (or a computer program product) for storing one or more programs for executing a method for performing communication by an electronic device may be described. According to an embodiment, the one or more programs may include instructions which, when executed by a processor of the electronic device, cause the electronic device to perform first communication by using a first power amplifier among multiple power amplifiers, perform second communication by using a second power amplifier among the multiple power amplifiers, identify a temperature of the electronic device 101 by using a temperature sensor while performing the first communication and the second communication, release the second communication in response to a situation in which the temperature of the electronic device exceeds a first predetermined threshold temperature, and switch a power amplifier that is to perform the first communication.

### [Advantageous Effects of Invention]

According to an embodiment, in response to performing an LTE fallback function, the electronic device may perform LTE communication by using a power amplifier (PA) not in use, or a power amplifier having a relatively low temperature, among multiple power amplifiers (PAs) (e.g., PAMs), thereby rapidly reducing the internal temperature of the electronic device.

According to an embodiment, the electronic device may support multiple communication schemes, based on a communication circuit including multiple power amplifiers. Each of the multiple power amplifiers may be operatively connected to an antenna corresponding to at least one communication scheme and may be used for communication based on the antenna. For example, in a specific communication environment, some of the power amplifiers may not be used for communication. According to an embodiment, in response to performing an LTE fallback function, the electronic device may switch a power amplifier used for LTE communication in a situation in which NR communication is released and LTE communication is maintained. For example, the electronic device may select a power amplifier not in use, a power amplifier having a relatively low temperature, or a power amplifier having a relatively low utilization ratio among the multiple power amplifiers, and maintain LTE communication, based on the selected power amplifier.

According to an embodiment, the electronic device may switch a power amplifier (PAM) used for LTE communication in response to performing an LTE fallback function, and may relatively rapidly lower the internal temperature of the electronic device. As the internal temperature of the electronic device rapidly decreases, the time point at which ENDC communication is resumed may be advanced, and the communication utilization of the electronic device may be improved. According to an embodiment, in a situation (e.g., LTE fallback) in which the communication environment is changed due to an increase in the internal temperature, the electronic device may switch a power amplifier used for LTE communication in order to lower the internal temperature.

The effects obtainable in the disclosure are not limited to the effects mentioned above, and other effects not mentioned may be clearly understood by those skilled in the art to which the disclosure pertains from the description below.

### [Brief Description of Drawings]

In describing the drawings, the same or similar reference numerals may be used for the same or similar components.
FIG. 1 is a block diagram of an electronic device in a network environment according to an embodiment of the disclosure.
FIG. 2 is an exemplary diagram illustrating a situation in which communication is switched from an ENDC communication situation to LTE communication by an LTE fallback function, and then switched back from the LTE communication to the ENDC communication, according to an embodiment of the disclosure.
FIG. 3 is a block diagram of an electronic device according to an embodiment of the disclosure.
FIG. 4 is a flowchart illustrating a first method for switching a power amplifier used for LTE communication in response to performing an LTE fallback function according to an embodiment of the disclosure.
FIG. 5 is a flowchart illustrating a second method for switching a power amplifier used for LTE communication in response to performing an LTE fallback function according to an embodiment of the disclosure.

### [Mode for the Invention]

Hereinafter, an embodiment of the disclosure will be described in detail with reference to the accompanying drawings so that the disclosure may be easily implemented by those skilled in the art to which the disclosure belongs. However, the disclosure may be implemented in various different forms and is not limited to embodiments described herein. In describing the drawings, the same or similar reference numerals may be used for the same or similar components. In addition, in the drawings and related descriptions, descriptions of well-known functions and configurations may be omitted for clarity and brevity.

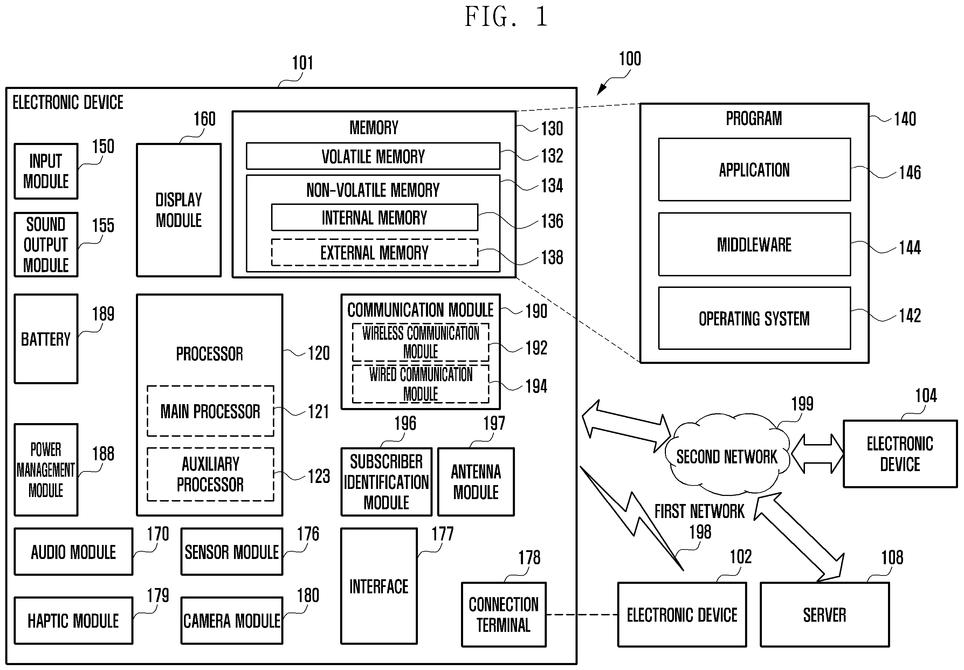

Fig. 1 is a block diagram illustrating an example electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102)(e.g., a speaker or a headphone) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). For example, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band. For example, the plurality of antennas may include a patch array antenna and/or a dipole array antenna.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

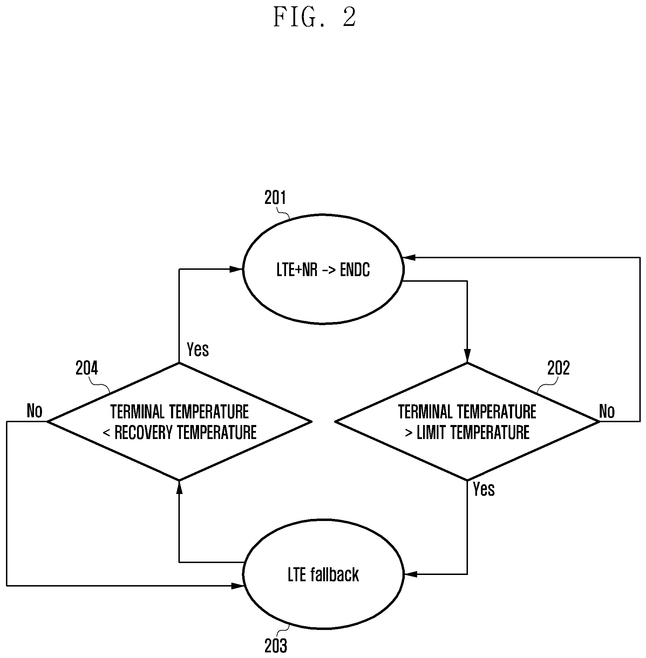

FIG. 2 is an exemplary diagram illustrating a situation in which a communication is switched from an ENDC communication situation to an LTE communication by an LTE fallback function, and then switched back from the LTE communication to an ENDC communication, according to an embodiment of the disclosure.

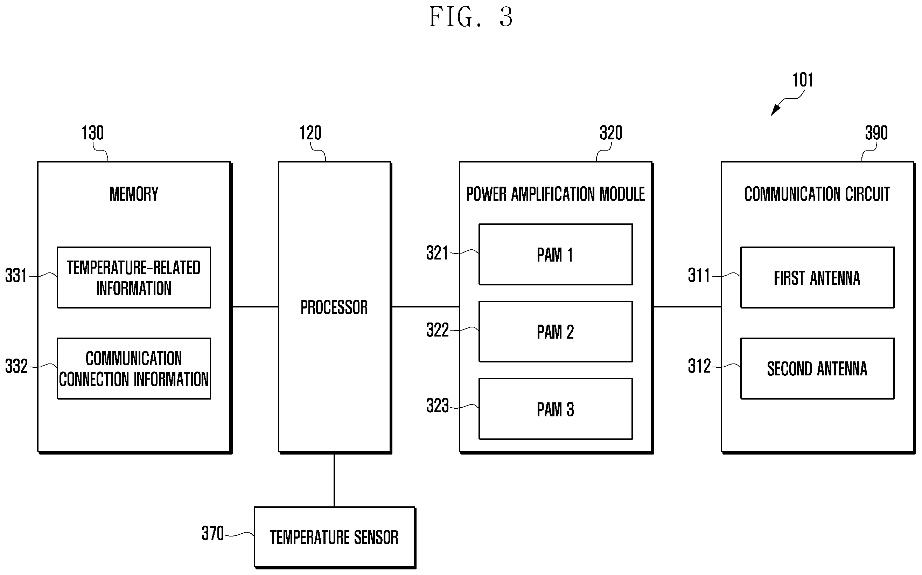

Referring to FIG. 2, an electronic device (e.g., the electronic device 101 in FIG. 1) may include multiple antennas (e.g., a first antenna 311 and a second antenna 312 in FIG. 3) for supporting multiple communication schemes (e.g., LTE communication and NR communication) and a power amplifier (PA) (e.g., a power amplification module 320) individually connected to each of the multiple antennas. For example, the electronic device may support E-UTRA NR dual connectivity (ENDC) communication. EN-DC communication may be a communication scheme that, based on LTE communication (e.g., 4G communication, LTE anchor) configured as a primary communication scheme, uses both LTE communication and NR communication (e.g., 5G communication) to increase the data transmission speed.

According to an embodiment, while performing ENDC communication, the electronic device 101 may transmit or receive a control signal and a data signal, based on first communication (e.g., LTE communication), and may transmit or receive a data signal, based on second communication (e.g., NR communication). In the ENDC communication situation, the communication speed according to data communication may be improved.

In operation 201, the electronic device 101 may be in an ENDC communication state in which LTE communication and NR communication are used together. For example, the electronic device 101 may perform ENDC communication, based on an antenna supporting LTE communication and an antenna supporting NR communication. According to an embodiment, the ENDC communication may be performed faster than the LTE communication, and the internal temperature of the electronic device 101 may increase more rapidly.

In operation 202, when the internal temperature of the electronic device 101 exceeds a limit temperature (e.g., a first predetermined threshold temperature), the electronic device 101 may perform an LTE fallback function in operation 203. For example, when the LTE fallback function is performed, in a state in which ENDC communication (e.g., LTE communication + NR communication) is being performed, the NR communication may be released while the LTE communication is maintained. According to an embodiment, when the internal temperature of the electronic device 101 rises and exceeds a predetermined temperature (e.g., the limit temperature), the electronic device 101 may perform an LTE fallback function to reduce the internal temperature. While the electronic device 101 performs both LTE communication and NR communication, the communication scheme may be switched such that only the LTE communication is performed.

When the internal temperature of the electronic device 101 is equal to or lower than the limit temperature in operation 202, the electronic device 101 may maintain the ENDC communication in operation 201.

In operation 203, the electronic device 101 may perform only the LTE communication by the LTE fallback function, and the internal temperature of the electronic device 101 may decrease. According to an embodiment, the electronic device 101 may switch the type of power amplifier (PAM) in performing LTE communication by using the LTE fallback function. The electronic device 101 may identify multiple power amplifiers supporting LTE communication, and may switch an existing PA to another PA. For example, the electronic device 101 may identify temperature corresponding to each of the power amplifiers and may switch an existing power amplifier to a power amplifier having a relatively low-temperature. For another example, the electronic device 101 may identify a transmission/reception ratio corresponding to each of the power amplifiers, and may switch an existing power amplifier to a power amplifier having a relatively lower transmission/reception ratio. The electronic device 101 may perform LTE communication by using the switched power amplifier. For example, the electronic device 101 may periodically or aperiodically identify the internal temperature.

In operation 204, when the internal temperature of the electronic device 101 drops below a recovery temperature (e.g., a second predetermined threshold temperature), the electronic device 101 may resume the ENDC communication in operation 201. In response to the internal temperature dropping below the recovery temperature, the electronic device 101 may switch the LTE communication to ENDC communication to improve communication efficiency.

According to an embodiment, the electronic device 101 may detect a situation in which the internal temperature exceeds the limit temperature due to ENDC communication use, and in response to the detection of the situation, perform an LTE fallback function. In response to performing the LTE fallback function, the electronic device 101 may select a power amplifier, among the multiple power amplifiers, which can relatively rapidly reduce the internal temperature, and may perform LTE communication by using the selected power amplifier. For example, the electronic device 101 may select a power amplifier having a relatively low temperature obtained based on the temperature corresponding to each of the multiple power amplifiers. When LTE communication is performed by using the power amplifier having the obtained low-temperature, the internal temperature of the electronic device 101 may drop more rapidly. According to an embodiment, in response to performing the LTE fallback function, the electronic device 101 may lower the internal temperature more rapidly and reduce the time required to resume ENDC. According to an embodiment, the electronic device 101 may rapidly solve the heat generation problem due to the ENDC communication, and may provide a user with an efficient communication service.

FIG. 3 is a block diagram of an electronic device according to an embodiment of the disclosure.

An electronic device 101 (e.g., the electronic device 101 in FIG. 1) in FIG. 3 may be at least partially similar to the electronic device 101 in FIG. 1, or may further include other embodiments of the electronic device. The electronic device 101 may include multiple antennas (e.g., a first antenna 311 and a second antenna 312) for supporting communication based on multiple communication frequency bands. A processor (e.g., the processor 120 in FIG. 1) of the electronic device 101 may use multiple communication frequency bands (e.g., an LTE frequency band and an NR frequency band) to perform ENDC communication in which LTE communication and NR communication are performed simultaneously. For example, the processor 120 may perform LTE communication, based on an LTE frequency band corresponding to the first antenna 311, while performing NR communication, based on an NR frequency band corresponding to the second antenna 312.

Referring to FIG. 3, an electronic device 101 may include a processor (e.g., the processor 120 in FIG. 1), a memory (e.g., the memory 130 in FIG. 1), a power amplification module 320, a temperature sensor 370, and/or a communication circuit 390 (e.g., the communication module 190 in FIG. 1). The communication circuit 390 may include multiple antennas (e.g., the first antenna 311 and the second antenna 312) electrically connected thereto. The power amplification module 320 may be disposed between the processor 120 and the antennas. The power amplification module 320 may include multiple power amplifiers (e.g., PAM1 321, PAM2 322, and PAM3 323). The power amplification module 320 may be a component including at least one power amplifier. For example, the processor 120 may perform network communication (e.g., LTE communication) based on a communication frequency band (e.g., the LTE frequency band) corresponding to the first antenna 311 by using the first power amplifier 321 (PAM1) operatively or electrically connected to the first antenna 311. As another example, the processor 120 may perform network communication (e.g., NR communication) based on a communication frequency band (e.g., the NR frequency band) corresponding to the second antenna 312 by using the second power amplifier 322 (PAM2) operatively or electrically connected to the second antenna 312. According to an embodiment, the electronic device 101 may perform, based on the multiple antennas, ENDC communication which substantially simultaneously uses multiple communication schemes (e.g., LTE communication and NR communication).

According to an embodiment, the processor 120 of the electronic device 101 may execute a program (e.g., the program 140 in FIG. 1) stored in the memory 130 to control at least one other component (e.g., a hardware or software component) and to perform various types of data processing or calculation. For example, the processor 120 may identify the internal temperature of the electronic device 101 by using the temperature sensor 370, and determine whether the identified internal temperature exceeds a first predetermined threshold temperature, based on temperature-related information 331 stored in the memory 130. When identifying a situation in which the internal temperature exceeds the first predetermined threshold temperature, the processor 120 may switch the communication scheme in the electronic device 101, based on communication connection information 332 stored in the memory 130. For example, the processor 120 may switch a power amplifier (e.g., PAM1 321, PAM2 322, or PAM3 323) connected to the first antenna 311 used for a first communication scheme (e.g., LTE communication) in response to the situation in which the internal temperature exceeds the first predetermined threshold temperature. In order to reduce the internal temperature of the electronic device 101 more rapidly, the processor 120 may switch the power amplifier corresponding to the first communication scheme. According to an embodiment, the processor 120 may be operatively, functionally, and/or electrically connected to the memory 130, the power amplification module 320, and/or the communication circuit 390.

According to an embodiment, the memory 130 may store the temperature-related information 331 related to the internal temperature of the electronic device 101 and the communication connection information 332 related to the communication scheme of the electronic device 101. For example, the temperature-related information 331 may include a limit temperature (e.g., a first threshold temperature) at which the operation of the electronic device 101 is partially restricted and a recovery temperature (e.g., a second threshold temperature) at which a restriction on the operation of the electronic device 101 is released. For example, the communication connection information 332, when communication according to a first communication scheme is performed in the electronic device 101, may include the type of an antenna corresponding to the first communication scheme, the type of power amplifier connected to the antenna, and information about connection between internal components corresponding to the first communication scheme.

According to an embodiment, the processor 120 may periodically or aperiodically identify the internal temperature of the electronic device 101 by using the temperature sensor 370. When the ENDC communication is performed, the processor 120 may detect whether the internal temperature of the electronic device 101 exceeds the first threshold temperature (e.g., the limit temperature). In response to a situation in which the internal temperature of the electronic device 101 exceeds a first threshold temperature, the processor 120 may switch a power amplifier connected to an antenna corresponding to a first communication scheme to reduce the internal temperature more rapidly. The processor 120 may select a power amplifier to be switched, based on the communication connection information 332, and may connect the selected power amplifier to the antenna corresponding to the first communication scheme.

According to an embodiment, the power amplification module 320 may include at least one power amplifier (e.g., PAM1 321, PAM2 322, or PAM3 323). For example, the power amplifier may perform the function of at least partially amplifying a transmission signal transmitted to the outside through an antenna, and the function of processing a reception signal acquired through an antenna. For example, the processor 120 may select, when performing a first communication scheme, the first antenna 311 supporting the first communication scheme, and identify one power amplifier connected to the selected first antenna 311. Based on the communication connection information 332, the processor 120 may identify a connection structure between components corresponding to a specific communication scheme.

According to an embodiment, the electronic device 101 may include multiple power amplifiers (e.g., PAM1 321, PAM2 322, and PAM3 323), and each of the power amplifiers may be used under the following conditions in Table 1.

**[Table 1]**

| Power Amplifier | Frequency Band | Communication Scheme |
|---|---|---|
| PAM3 323 | UHB | NR Communication |
| PAM2 322 | MB, HB | LTE Communication, NR Communication |
| PAM1 321 | LB, MB | LTE Communication |
| | HB | LTE Communication, NR Communication |

Referring to Table 1, the processor 120 may perform NR communication (e.g., 5G communication) corresponding to an ultra-high band (UHB) frequency band (e.g., an ultra-high frequency band), based on an antenna connected to PAM3 323. The processor 120 may perform communication schemes (e.g., LTE communication and NR communication) corresponding to a middle band (MB) frequency band (e.g., a medium frequency band) and a high band (HB) frequency band (e.g., a high frequency band), based on an antenna connected to PAM2 322. The processor 120 may perform LTE communication (e.g., 4G communication) corresponding to a low band (LB) frequency band (e.g., a low frequency band) and a middle band (MB) frequency band (e.g., a medium frequency band), based on an antenna connected to PAM1 321, and may perform a communication scheme (e.g., LTE communication, NR communication) corresponding to a high band (HB) frequency band (e.g., a high frequency band), based on the antenna connected to PAM1 321. For example, the LTE communication (e.g., 4G communication) may be performed based on the LB frequency band, the MB frequency band, and the HB frequency band. The NR communication (e.g., 5G communication) may be performed based on the MB frequency band, the HB frequency band, and the UHB frequency band.

According to an embodiment, when NR communication corresponding to the UHB frequency band is performed, the electronic device 101 may electrically connect PAM3 323 to an antenna corresponding to the NR communication. When LTE communication corresponding to the HB frequency band is performed, the electronic device 101 may electrically connect PAM2 322 or PAM1 321 to an antenna corresponding to LTE communication. For example, when ENDC communication (e.g., LTE communication + NR communication) is performed, the electronic device 101 may connect PAM1 321 to the first antenna 311 corresponding to LTE communication, and may connect PAM3 323 to the second antenna 312 corresponding to NR communication.

According to an embodiment, the first antenna 311 of the communication circuit 390 may include an antenna supporting first communication (e.g., LTE communication), and the second antenna 312 of the communication circuit 390 may support second communication (e.g., NR communication). When performing ENDC communication, the electronic device 101 may perform the first communication (e.g., LTE communication) based on the first antenna 311 while performing the second communication (e.g., NR communication) based on the second antenna 312.

According to an embodiment, when ENDC communication is performed, the electronic device 101 may perform first communication (e.g., LTE communication) based on a first communication frequency (e.g., a frequency band for LTE communication) by using a first power amplifier (e.g., PAM1 321) among the multiple power amplifiers, and perform second communication (e.g., NR communication) based on a second communication frequency (e.g., a frequency band for NR communication) by using a third power amplifier (e.g., PAM3 323) among the multiple power amplifiers. When performing ENDC communication, the electronic device 101 may substantially perform the first communication (e.g., LTE communication) and the second communication (e.g., NR communication) together.

According to an embodiment, the temperature sensor 370 may be at least partially disposed inside the electronic device 101 and may measure the internal temperature of the electronic device 101. The processor 120 may measure the internal temperature of the electronic device 101 by using the temperature sensor 370, and at least partially control the operation of the electronic device 101, based on the measured internal temperature.

According to an embodiment, in a situation in which ENDC communication is being performed, the processor 120 of the electronic device 101 may use the temperature sensor 370 to measure the internal temperature of the electronic device 101. The processor 120 may detect a situation in which the measured internal temperature exceeds the first predetermined threshold temperature (e.g., the limit temperature), and in response to the detection of the situation, perform an LTE fallback function. For example, the LTE fallback function may be a function of releasing NR communication (e.g., 5G communication) and maintaining only LTE communication (e.g., 4G communication) during a state (e.g., ENDC communication state) in which LTE communication and NR communication are performed together. LTE communication may be performed based on the first antenna 311 and the first power amplifier (e.g., PAM1 321) connected to the first antenna 311, and NR communication may be performed based on the second antenna 312 and the third power amplifier (e.g., PAM3 323) connected to the second antenna 312. According to an embodiment, in response to performing the LTE fallback function, the electronic device 101 may release the NR communication based on the second antenna 312 and maintain only the LTE communication based on the first antenna 311. The processor 120 may switch the power amplifier electrically or operatively connected to the first antenna 311 in response to performing the LTE fallback function. For example, the processor 120 may switch the existing power amplifier (e.g., the first power amplifier (PAM1 321)) connected to the first antenna 311 to a second power amplifier (e.g., PAM2 322) not used in ENDC communication, or may switch the existing power amplifier to the third power amplifier (e.g., PAM3 323) used in the released NR communication. According to an embodiment, the second power amplifier (PAM2) has not been used in ENDC communication, and thus may be in a relatively lower temperature state than the first amplifier (PAM1).

According to an embodiment, in a situation in which ENDC communication is being performed, the processor 120 may perform LTE communication by using the first power amplifier (e.g., PAM1 321), based on frequency division duplexing (FDD), and perform NR communication by using the second power amplifier (e.g., PAM2 322), based on time division duplexing (TDD). In response to performing the LTE fallback function, the processor 120 may release the NR communication using the second power amplifier (e.g., PAM2 322), and may maintain only the LTE communication using the first power amplifier (e.g., PAM1 321). In response to performing the LTE fallback function, the processor 120 may switch the first power amplifier 321 electrically or operatively connected to the first antenna 311 to another power amplifier. For example, the first power amplifier 321 according to the frequency division duplexing may have a relatively higher temperature than the second power amplifier 322 according to the time division duplexing. In response to the performance of the LTE fallback function, the processor 120 may switch the first power amplifier 321 electrically or operatively connected to the first antenna 311 to the second power amplifier 322. According to an embodiment, in response to performing the LTE fallback function, the processor 120 may switch the first power amplifier 321 being used for LTE communication to the second power amplifier 322, and may perform LTE communication by using the switched second power amplifier 322.

According to an embodiment, in a situation in which ENDC communication is performed, the processor 1120 may perform LTE communication by using the first power amplifier 321, based on time division duplex (TDD), and may perform NR communication by using the second power amplifier 322, based on time division duplex (TDD) scheme. In response to performing the LTE fallback function, the processor 120 may release the NR communication using the second power amplifier (e.g., PAM2 322), and maintain only the LTE communication using the first power amplifier (e.g., PAM1 321). In response to performing the LTE fallback function, the processor 120 may calculate a first transmission/reception ratio (e.g., a first duty rate) corresponding to the first power amplifier 321 and a second transmission/reception ratio (e.g., a second duty rate) corresponding to the second power amplifier 322. The processor 120 may compare and analyze the first transmission/reception ratio and the second transmission/reception ratio, and select a power amplifier with a relatively low transmission/reception ratio. For example, the low transmission/reception ratio means that the power amplifier is relatively less used in a communication situation, and may mean that the temperature of the power amplifier is relatively low. According to an embodiment, when the second transmission/reception ratio is lower than the first transmission/reception ratio, the processor 120, upon performing the LTE fallback function, may switch the first power amplifier 321 being used for LTE communication to the second power amplifier 322, and may perform LTE communication by using the switched second power amplifier 322.

According to an embodiment, an electronic device (e.g., the electronic device 101 in FIGS. 1 and 3) may include a temperature sensor (e.g., the temperature sensor 370 in FIG. 3), multiple power amplifiers (e.g., PAM1 321, PAM2 322, and PAM3 323 in FIG. 3), a memory (e.g., the memory 130 in FIGS. 1 and 3), and a processor (e.g., the processor 120 in FIGS. 1 and 3) operatively connected to the temperature sensor 370, the power amplification module 320, and the memory 130. According to an embodiment, the processor 120 may perform first communication (e.g., LTE communication) by using a first power amplifier 321 among the multiple power amplifiers 321, 322, and 323. The processor 120 may perform second communication (e.g., NR communication) by using a second power amplifier among the multiple power amplifiers 321, 322, and 323. The processor 120 may identify the temperature (e.g., internal temperature) of the electronic device 101 by using the temperature sensor 370 while performing the first communication and the second communication. The processor 120 may release the second communication in response to a situation in which the temperature of the electronic device 101 exceeds a first predetermined threshold temperature. The processor 120 may switch a power amplifier that is to perform the first communication.

According to an embodiment, the processor 120 may identify a third power amplifier, among the multiple power amplifiers 321, 322, and 323, which is not used for the first communication and the second communication. In response to the situation in which the temperature of the electronic device 101 exceeds the first predetermined threshold temperature, the processor 120 may switch the first power amplifier 321 to the third power amplifier. The processor 120 may perform the first communication by using the switched third power amplifier.

According to an embodiment, the processor 120 may switch the first power amplifier 321 corresponding to the first communication to the second power amplifier in response to the release of the second communication. The second power amplifier may be supplied with relatively lower power than the first power amplifier 321 in a communication situation.

According to an embodiment, in response to the release of the second communication, the processor 120 may switch the first power amplifier 321 corresponding to the first communication to the second power amplifier. The first power amplifier 321 may support the first communication based on frequency division duplexing (FDD), and the second power amplifier may support the second communication based on time division duplexing (TDD).

According to an embodiment, in response to the situation in which the temperature of the electronic device 101 exceeds the first predetermined threshold temperature, the processor 120 may identify a first transmission/reception ratio corresponding to the first communication and a second transmission/reception ratio corresponding to the second communication. The processor 120 may switch the first power amplifier 321 connected to the first communication to the second power amplifier, based on the first transmission/reception ratio and the second transmission/reception ratio, when the first transmission/reception ratio is relatively higher than the second transmission/reception ratio.

According to an embodiment, the processor 120 may maintain the first power amplifier 321 corresponding to the first communication, based on the first transmission/reception ratio and the second transmission/reception ratio, when the first transmission/reception ratio is relatively lower than the second transmission/reception ratio.

According to an embodiment, in response to the release of the second communication, the processor 120 may identify the temperature of the electronic device 101 by using the temperature sensor 370. In response to a situation in which the temperature of the electronic device 101 is lower than a second predetermined threshold temperature, the processor 120 may resume the second communication.

According to an embodiment, when the first communication is being performed based on the first power amplifier 321, the processor 120 may resume the second communication, based on the second power amplifier.

According to an embodiment, the processor 120 may switch the first power amplifier 321 corresponding to the first communication to the second power amplifier in response to the situation in which the temperature of the electronic device 101 is lower than the second predetermined threshold temperature. The processor 120 may resume the second communication, based on the first power amplifier 321.

According to an embodiment, the processor 120 may transmit or receive a control signal and a data signal, based on the first communication. The processor 120 may transmit or receive a data signal, based on the second communication. The processor 120 may determine whether to release a communication connection corresponding to the second communication, through the control signal based on the first communication.

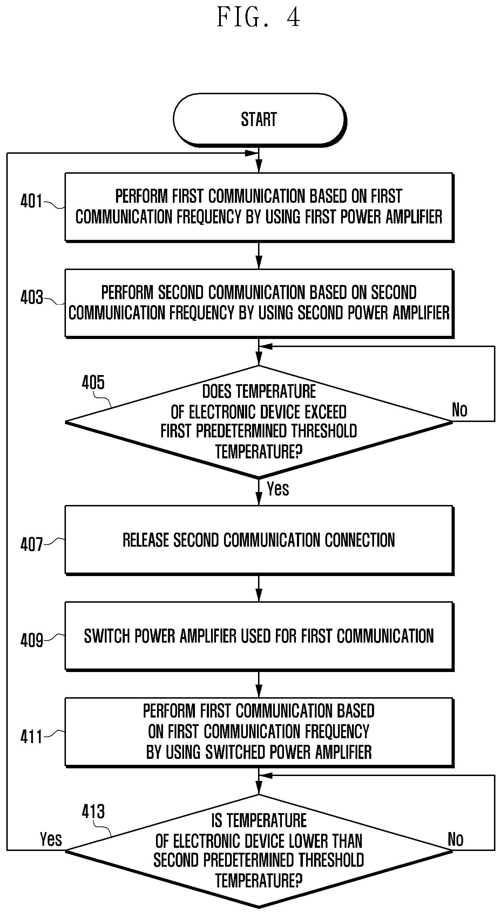

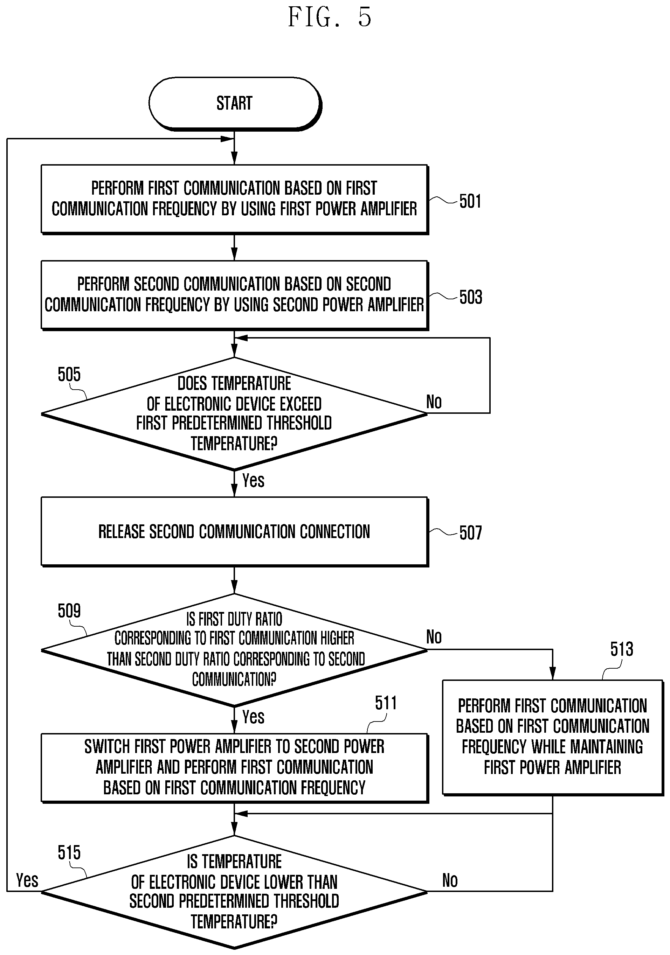

FIG. 4 is a flowchart illustrating a first method for switching a power amplifier used for LTE communication in response to performing an LTE fallback function according to an embodiment of the disclosure. FIG. 5 is a flowchart illustrating a second method for switching a power amplifier used for LTE communication in response to performing an LTE fallback function according to an embodiment of the disclosure.

In the following embodiments, operations may be performed sequentially, but are not necessarily performed sequentially. For example, the order of the operations may be changed, and at least two operations may be performed in parallel.

According to an embodiment, some of the operations illustrated in FIG. 4 may be the same as the operations illustrated in FIG. 5, and descriptions of some of the operations in FIG. 5 may be replaced with descriptions of the operations in FIG. 4.

According to an embodiment, operations 401 to 413 illustrated in FIG. 4 and operations 501 to 515 illustrated in FIG. 5 may be understood to be performed by a processor (e.g., the processor 120 in FIGS. 1 and 3) of an electronic device (e.g., the electronic device 101 in FIGS. 1 and 3).

The electronic device 101 in FIGS. 4 and 5 may at least partially similar to the electronic device in FIGS. 1 and 3, or may further include other embodiments of the electronic device. The electronic device 101 may include multiple antennas (e.g., the first antenna 311 and the second antenna 312 in FIG. 3) for supporting communication (e.g., LTE communication or NR communication) based on multiple communication frequency bands (e.g., an LTE frequency band and NR frequency band). The processor 120 of the electronic device 101 may use the multiple communication frequency bands (e.g., an LTE frequency band and an NR frequency band) to perform ENDC communication in which LTE communication and NR communication are performed simultaneously. For example, the processor 120 may perform LTE communication, based on the LTE frequency band corresponding to the first antenna 311, while performing NR communication, based on the NR frequency band corresponding to the second antenna 312. Between the processor 120 and the antennas, a power amplification module (e.g., the power amplification module 320 in FIG. 3) including at least one power amplifier (e.g., PAM1 321, PAM2 322, or PAM3 323 in FIG. 3) may be disposed. According to an embodiment, a first power amplifier (e.g., PAM1 321, a power amplifier supporting the LTE frequency band) may be operatively or electrically connected to the first antenna 311 (e.g., an LTE antenna). A second power amplifier (e.g., a power amplifier supporting the NR frequency band) may be operatively or electrically connected to the second antenna 312 (e.g., an NR antenna).

Referring to FIG. 4, in operation 401, the processor 120 of the electronic device 101 may perform first communication (e.g., LTE communication) based on a first communication frequency (e.g., an LTE frequency band) by using a first power amplifier (e.g., PAM1 321). For example, the processor 120 may perform LTE communication corresponding to the LTE frequency band, based on the first antenna 311 (e.g., the LTE antenna). The first power amplifier (e.g., PAM1 321) may be operatively or electrically connected to the first antenna 311, and may be used for a transmission signal and a reception signal according to the LTE communication.

In operation 403, the processor 120 may perform second communication (e.g., NR communication) based on a second communication frequency (e.g., an NR frequency band) by using a second power amplifier. For example, the processor 120 may perform NR communication corresponding to the NR frequency band, based on the second antenna 312 (e.g., the NR antenna). The second power amplifier may be operatively or electrically connected to the second antenna 312, and may be used for a transmission signal and a reception signal according to the NR communication.

In operations 401 and 403, the processor 120 may be in an E-UTRA NR dual connectivity (ENDC) communication state in which the first communication and the second communication are substantially used together. For example, ENDC communication may be a communication scheme that based on LTE communication (e.g., the first communication in operation 401, 4G communication, or LTE anchor) configured as a primary communication scheme, increases data transmission speed by using LTE communication and NR communication (e.g., the second communication in operation 403 or 5G communication) together.

In operation 405, the processor 120 may measure the temperature (e.g., internal temperature) of the electronic device 101 by using a temperature sensor (e.g., the temperature sensor 370 in FIG. 3), and determine whether the temperature exceeds a first predetermined threshold temperature (e.g., a limit temperature). For example, the first predetermined threshold temperature may be stored in a memory (e.g., the memory 130 in FIGS. 1 and 3). According to an embodiment, a situation in which the internal temperature of the electronic device 101 exceeds the first predetermined threshold temperature may include a situation in which the electronic device 101 has become overheated due to ENDC communication.

In operation 405, when the internal temperature of the electronic device 101 exceeds the first predetermined threshold temperature, the processor 120 may release a connection of the second communication (e.g., the NR communication) in operation 407. Operation 407 may include a situation in which an LTE fallback function is performed in an ENDC communication state. For example, the processor 120 may stop the ENDC communication. The processor 120 may release the second communication (e.g., the NR communication) while maintaining the first communication (e.g., the LTE communication).

In operation 409, the processor 120 may switch a power amplifier used for the first communication (e.g., the LTE communication). For example, the processor 120 may switch the first power amplifier (e.g., PAM1 321) being used for the first communication to another power amplifier (e.g., PAM2 322 or PAM3 323). For example, the other power amplifier (e.g., PAM2 322 or PAM3 323) to which the switching is made may be supplied with relatively lower power than the first power amplifier (e.g., PAM1 321). The processor 120 may perform a switching operation such that the first power amplifier (e.g., PAM1 321) connected to the first antenna 311 is switched to another power amplifier (e.g., PAM2 322 or PAM3 323). According to an embodiment, the processor 120 may switch the first power amplifier (e.g., PAM1 321) to another power amplifier not used for the first communication (e.g., the LTE communication) and the second communication (e.g., the NR communication). According to an embodiment, the processor 120 may select a power amplifier having a relatively low temperature from among multiple power amplifiers, and switch the first power amplifier (e.g., PAM1 321) to the selected power amplifier. According to an embodiment, in performing the first communication (e.g., the LTE communication), the electronic device 101 may use a switched power amplifier, so that the internal temperature of the electronic device 101 may decrease more rapidly.

In operation 411, the processor 120 may perform first communication (e.g., LTE communication) based on the first communication frequency (e.g., the LTE frequency band) by using the switched power amplifier (e.g., PAM2 322). In response to performing the LTE fallback function, the processor 120 may release the second communication (e.g., the NR communication), while maintaining only the first communication (e.g., the LTE communication).

In operation 413, the processor 120 may determine whether the temperature of the electronic device 101 is lower than a second predetermined threshold temperature (e.g., a recovery temperature). For example, in a situation in which the first communication (e.g., the LTE communication) is maintained by LTE fallback, the processor 120 may periodically or aperiodically identify the internal temperature of the electronic device 101, based on the temperature sensor 370. When it is identified that the internal temperature of the electronic device 101 is lower than the second predetermined threshold temperature, the processor 120 may resume ENDC communication in operation 401. For example, the processor 120 may perform a switching operation so that the second communication (e.g., the NR communication) is performed together while the first communication (e.g., the LTE communication) is being performed. For example, when the EN-DC communication is resumed, PAM3 323, which corresponds to the second power amplifier, may be connected to the second antenna 312, and the second communication (e.g., the NR communication) may be performed using PAM3 323. In operation 413, the processor 120 may perform the first communication by using the switched power amplifier (e.g., PAM2 322), and in operation 401, the processor 120 may continuously perform the first communication while maintaining the switched power amplifier (e.g., PAM2 322). According to an embodiment, the processor 120 may, in resuming the ENDC communication, connect PAM1 321 corresponding to the first power amplifier to the first antenna 311, and may perform the first communication (e.g., the LTE communication) by using PAM1 321.

Referring to FIG. 5, operations 501 to 507 are the same as operations 401 to 407 in FIG. 4, and thus descriptions thereof may be replaced by the descriptions related to operations 401 to 407.

In operation 501, the processor 120 may perform first communication (e.g., LTE communication) based on a first communication frequency (e.g., an LTE frequency band) by using a first power amplifier (e.g., PAM1 321). For example, the first power amplifier (e.g., PAM1 321) may be operatively or electrically connected to the first antenna 311 and may support communication in the LTE frequency band.

In operation 503, the processor 120 may perform second communication (e.g., NR communication) based on a second communication frequency (e.g., an NR frequency band) by using a second power amplifier. For example, the second power amplifier may be operatively or electrically connected to the second antenna 312 and may support communication in the NR frequency band.

In operations 501 and 503, the processor 120 may be in an E-UTRA NR dual connectivity (ENDC) communication state in which the first communication and the second communication are substantially used together. For example, the processor 120 may perform the first communication (e.g., the LTE communication) by using PAM1 321, and may perform the second communication (e.g., the NR communication) together with the first communication by using PAM2 322.

In operation 505, the processor 120 may measure the temperature (e.g., internal temperature) of the electronic device 101 by using the temperature sensor 370 and determine whether the temperature exceeds a first predetermined threshold temperature (e.g., a limit temperature).

When the internal temperature of the electronic device 101 exceeds the first predetermined threshold temperature in operation 505, the processor 120 may release a connection of the second communication (e.g., the NR communication) in operation 507. Operation 507 may be a situation in which an LTE fallback function is performed in an ENDC communication state.

In operation 509, the processor 120 may determine whether a first duty ratio (e.g., a first transmission/reception ratio) corresponding to the first communication (e.g., the LTE communication) is higher than a second duty ratio (e.g., a second transmission/reception ratio) corresponding to the second communication (e.g., the NR communication). For example, the processor 120 may identify the first transmission/reception ratio corresponding to the first power amplifier (e.g., PAM1 321) connected to the first antenna 311 and the second transmission/reception ratio corresponding to the second power amplifier connected to the second antenna 312. In response to performing the LTE fallback function, the processor 120 may select a power amplifier identified as having a relatively low transmission/reception ratio in order to reduce the internal temperature of the electronic device 101 more rapidly. For example, the low transmission/reception ratio may indicate that the power amplifier is relatively less used in the communication situation, and may also indicate that the temperature of the power amplifier is relatively low. According to an embodiment, the processor 120 may compare the first duty ratio (e.g., the first transmission/reception ratio) with the second duty ratio (e.g., the second transmission/reception ratio) to select a power amplifier with a relatively lower temperature.

In operation 509, when the first duty ratio (e.g., the first transmission/reception ratio) is higher than the second duty ratio (e.g., the second transmission/reception ratio), in operation 511, the processor 120 may switch the first power amplifier (e.g., PAM1 321) being used for the first communication (e.g., the LTE communication) to the second power amplifier (e.g., PAM2 322), and perform the first communication (e.g., the LTE communication) based on the first communication frequency (e.g., the LTE frequency band) by using the changed power amplifier (e.g., PAM2 322). For example, the fact that the first duty ratio (e.g., the first transmission/reception ratio) is relatively higher than the second duty ratio (e.g., the second transmission/reception ratio) may include the fact that the temperature of PAM1 321 corresponding to the first power amplifier is relatively higher than the temperature of PAM2 322 corresponding to the second power amplifier. PAM1 321 corresponding to the first power amplifier may be identified as having a relatively higher temperature than PAM2 322 corresponding to the second power amplifier. According to an embodiment, in response to performing the LTE fallback function, the electronic device 101 may select, in order to maintain LTE communication, a power amplifier having a relatively low temperature from among multiple power amplifiers, and perform LTE communication by using the selected power amplifier. By using the power amplifier having a low temperature, the internal temperature of the electronic device 101 may decrease relatively rapidly.

According to an embodiment, when the second communication (e.g., the NR communication) is performed based on time division duplexing (TDD), the processor 120 may compare and analyze the first duty ratio (e.g., the first transmission/reception ratio) corresponding to the first communication (e.g., the LTE communication) and a second duty ratio (e.g., second transmission/reception ratio) corresponding to the second communication (e.g., the NR communication). For example, when the second communication (e.g., the NR communication) is performed based on a high band (HB) frequency band (e.g., a high frequency band), the second communication may be performed according to time division duplexing (TDD). Referring to the above-described Table 1, PAM1 321 and PAM2 322 may support NR communication (e.g., the second communication), based on the HB frequency band (e.g., the high frequency band).

According to an embodiment, in a situation in which the second communication (e.g., the NR communication) is performed using PAM1 321 and PAM2 322, the processor 120 may compare the first transmission/reception ratio corresponding to the first communication with the second transmission/reception ratio corresponding to the second communication, and select a power amplifier having a relatively lower transmission/reception ratio (e.g., a relatively lower temperature). According to an embodiment, in response to performing the LTE fallback function, the electronic device 101 may perform LTE communication by using the power amplifier having the relatively lower transmission/reception ratio (e.g., the relatively lower temperature), and thus may reduce the internal temperature of the electronic device 101 more rapidly.

According to an embodiment, when the first communication (e.g., the LTE communication) is performed based on frequency division duplexing (FDD) and the second communication (e.g., the NR communication) is performed based on time division duplexing (TDD), a power amplifier corresponding to the second communication may be identified as having a relatively lower temperature than a power amplifier corresponding to the first communication. For example, in a state (e.g., ENDC communication) in which LTE communication according to frequency division duplexing (FDD) and NR communication according to time division duplexing (TDD) are being performed, when an LTE fallback function is performed, operation 509 in FIG. 5 may be omitted. The processor 120 of the electronic device 101 may switch the first power amplifier being used for the first communication (e.g., (FDD)_LTE communication) to the second power amplifier being used for the second communication (e.g., (TDD)_NR communication), without comparing the transmission/reception ratios, and perform the first communication, based on the switched second power amplifier.

When the first duty ratio (e.g., the first transmission/reception ratio) is lower than the second duty ratio (e.g., the second transmission/reception ratio) in operation 509, the processor 120 may, in operation 513, maintain the first power amplifier (e.g., PAM1 321) being used for the first communication (e.g., the LTE communication) while performing the first communication (e.g., the LTE communication) based on the first communication frequency (e.g., the LTE frequency band). The fact that the first transmission/reception ratio is lower than the second transmission/reception ratio may mean that PAM1 321 corresponding to the first power amplifier has a relatively lower temperature than PAM2 322 corresponding to the second power amplifier. According to an embodiment, in response to performing the LTE fallback function, the electronic device 101, in order to maintain LTE communication, may select a power amplifier having a relatively low temperature from among the multiple power amplifiers, and may perform the LTE communication by using the selected power amplifier. By using the power amplifier having the low temperature, the internal temperature of the electronic device 101 may decrease relatively rapidly.

In operation 515, the processor 120 may determine whether the temperature of the electronic device 101 is lower than a second predetermined threshold temperature (e.g., a recovery temperature). For example, the processor 120 may periodically or aperiodically identify the internal temperature of the electronic device 101 by using the temperature sensor 370, in a situation in which the first communication (e.g., the LTE communication) is maintained by LTE fallback. When it is identified that the internal temperature of the electronic device 101 is lower than the second predetermined threshold temperature, the processor 120 may resume the ENDC communication in operation 501. For example, the processor 120 may perform a switching operation so that a second communication (e.g., the NR communication) is performed together while the first communication (e.g., the LTE communication) is being performed. For example, when the ENDC communication is resumed, the second power amplifier may be connected to the second antenna 312, and the second communication (e.g., the NR communication) may be performed by using the second power amplifier. In operation 513, the processor 120 may perform the first communication by using the switched power amplifier (e.g., PAM2 322), and in operation 501, the processor 120 may switch the switched power amplifier (e.g., PAM2 322) back to the first power amplifier (e.g., PAM1 321), and may perform the first communication by using the first power amplifier. According to an embodiment, in resuming the ENDC communication, the processor 120 may electrically connect PAM1 321, corresponding to the first power amplifier, to the first antenna 311, and may perform the first communication (e.g., the LTE communication) by using PAM1 321.

According to an embodiment, a method for performing communication by an electronic device may include an operation of performing first communication by using a first power amplifier 321 among multiple power amplifiers 321, 322, and 323, an operation of performing second communication by using a second power amplifier among the multiple power amplifiers 321, 322, and 323, an operation of identifying the temperature of the electronic device 101 by using a temperature sensor 370 while performing the first communication and the second communication, an operation of releasing the second communication in response to a situation in which the temperature of the electronic device 101 exceeds a first predetermined threshold temperature, and an operation of switching a power amplifier that is to perform the first communication.

According to an embodiment, the method may further include an operation of identifying a third power amplifier, among the multiple power amplifiers 321, 322, and 323, that is not used for the first communication and the second communication; an operation of switching the first power amplifier 321 to the third power amplifier in response to the situation in which the temperature of the electronic device 101 exceeds the first predetermined threshold temperature; and an operation of performing the first communication by using the switched third power amplifier.

According to an embodiment, the operation of switching the power amplifier corresponding to the first communication may include an operation of switching the first power amplifier 321 corresponding to the first communication to the second power amplifier in response to the release of the second communication. According to an embodiment, the second power amplifier may be supplied with relatively lower power than the first power amplifier 321 in a communication situation.

According to an embodiment, the operation of switching the power amplifier corresponding to the first communication may include an operation of switching the first power amplifier 321 corresponding to the first communication to the second power amplifier in response to the release of the second communication. According to an embodiment, the first power amplifier 321 may support the first communication based on frequency division duplexing (FDD), and the second power amplifier may support the second communication based on time division duplexing (TDD).

According to an embodiment, the method may further include an operation of identifying a first transmission/reception ratio corresponding to the first communication and a second transmission/reception ratio corresponding to the second communication in response to the situation in which the temperature of the electronic device 101 exceeds the first predetermined threshold temperature, an operation of switching the first power amplifier 321 connected to the first communication to the second power amplifier, based on the first transmission/reception ratio and the second transmission/reception ratio, when the first transmission/reception ratio is relatively higher than the second transmission/reception ratio, and an operation of maintaining the first power amplifier 321 corresponding to the first communication, based on the first transmission/reception ratio and the second transmission/reception ratio, when the first transmission/reception ratio is relatively lower than the second transmission/reception ratio.

According to an embodiment, the method may further include an operation of identifying the temperature of the electronic device 101 by using the temperature sensor 370 in response to the release of the second communication, and an operation of resuming the second communication in response to a situation in which the temperature of the electronic device 101 is lower than a second predetermined threshold temperature.

According to an embodiment, the method may further include an operation of resuming the second communication, based on the second power amplifier, when the first communication is being performed based on the first power amplifier 321.

According to an embodiment, the method may further include an operation of switching the first power amplifier 321 corresponding to the first communication to the second power amplifier in response to the situation in which the temperature of the electronic device 101 is lower than the second predetermined threshold temperature, and an operation of resuming the second communication, based on the first power amplifier 321.

According to an embodiment, the method may further include an operation of transmitting or receiving a control signal and a data signal, based on the first communication, an operation of transmitting or receiving a data signal, based on the second communication; and an operation of determining whether to release a communication connection corresponding to the second communication, through the control signal based on the first communication.

According to an embodiment, a non-transitory computer-readable storage medium storing one or more programs for executing a method for performing communication by an electronic device 101 may be described. According to an embodiment, the one or more programs may include instructions which, when executed by a processor 120 of the electronic device 101, cause the electronic device to perform an operation of performing first communication by using a first power amplifier 321 among multiple power amplifiers 321, 322, and 323, an operation of performing second communication by using a second power amplifier among the multiple power amplifiers 321, 322, and 323, an operation of identifying the temperature of the electronic device 101 by using a temperature sensor 370 while performing the first communication and the second communication, an operation of releasing the second communication in response to a situation in which the temperature of the electronic device 101 exceeds a first predetermined threshold temperature, and an operation of switching a power amplifier that is to perform the first communication.

The electronic device according to various embodiments may be one of various types of electronic devices. The electronic devices may include, for example, a portable communication device (e.g., a smartphone), a computer device, a portable multimedia device, a portable medical device, a camera, a wearable device, a home appliance, or the like. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. It is intended that features described with respect to separate embodiments, or features recited in separate claims, may be combined unless such a combination is explicitly specified as being excluded or such features are incompatible. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), the element may be coupled with the other element directly (e.g., wiredly), wirelessly, or via a third element.

As used in connection with various embodiments of the disclosure, the term "module" may include a unit implemented in hardware, software, or firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the "non-transitory" storage medium is a tangible device, and may not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a temperature sensor (370);
multiple power amplifiers (321, 322, and 323);
a memory (130); and
a processor (120) operatively connected to the temperature sensor (370), the multiple power amplifiers (321, 322, and 323), and the memory (130),
wherein the processor (120) is configured to:
perform first communication by using a first power amplifier (321) among the multiple power amplifiers;
perform second communication by using a second power amplifier among the multiple power amplifiers;
identify a temperature of the electronic device (101) by using the temperature sensor (370) while performing the first communication and the second communication;
in response to a situation in which the temperature of the electronic device (101) exceeds a first predetermined threshold temperature, release the second communication; and
switch a power amplifier which is to perform the first communication.

2. The electronic device of claim 1, wherein the processor (120) is configured to:
identify, among the multiple power amplifiers (321, 322, and 323), a third power amplifier which is not used for the first communication and the second communication;
in response to the situation in which the temperature of the electronic device (101) exceeds the first predetermined threshold temperature, switch the first power amplifier (321) to the third power amplifier; and
perform the first communication by using the switched third power amplifier.

3. The electronic device of claim 1, wherein the processor (120) is configured to, in response to the release of the second communication, switch the first power amplifier (321) corresponding to the first communication to the second power amplifier, and
wherein the second power amplifier is configured to be supplied with relatively lower power than the first power amplifier (321) in a communication situation.

4. The electronic device of claim 1, wherein the processor (120) is configured to, in response to the release of the second communication, switch the first power amplifier (321) corresponding to the first communication to the second power amplifier,
wherein the first power amplifier (321) is configured to support the first communication based on frequency division duplexing (FDD), and
wherein the second power amplifier is configured to support the second communication based on time division duplexing (TDD).

5. The electronic device of claim 1, wherein the processor (120) is configured to:
in response to the situation in which the temperature of the electronic device (101) exceeds the first predetermined threshold temperature, identify a first transmission/reception ratio corresponding to the first communication and a second transmission/reception ratio corresponding to the second communication;
based on the first transmission/reception ratio and the second transmission/reception ratio, switch the first power amplifier (321) connected with the first communication to the second power amplifier in case that the first transmission/reception ratio is relatively higher than the second transmission/reception ratio; and
based on the first transmission/reception ratio and the second transmission/reception ratio, maintain the first power amplifier (321) corresponding to the first communication in case that the first transmission/reception ratio is relatively lower than the second transmission/reception ratio.

6. The electronic device of claim 1, wherein the processor (120) is configured to:
in response to the release of the second communication, identify the temperature of the electronic device (101) by using the temperature sensor (370); and
in response to a situation in which the temperature of the electronic device (101) is lower than a second predetermined threshold temperature, resume the second communication.

7. The electronic device of claim 6, wherein the processor (120) is configured to, in case that the first communication is being performed based on the first power amplifier (321), resume the second communication, based on the second power amplifier.

8. The electronic device of claim 6, wherein the processor (120) is configured to:
in response to the situation in which the temperature of the electronic device (101) is lower than the second predetermined threshold temperature, switch the first power amplifier (321) corresponding to the first communication to the second power amplifier; and
resume the second communication, based on the first power amplifier (321).

9. The electronic device of claim 1, wherein the processor (120) is configured to:
transmit or receive a control signal and a data signal, based on the first communication;
transmit or receive a data signal, based on the second communication; and
determine, through the control signal based on the first communication, whether to release a communication connection corresponding to the second communication,.

10. A method for performing communication by an electronic device, the method comprising:
performing first communication by using a first power amplifier (321) among multiple power amplifiers (321, 322, and 323);
performing second communication by using a second power amplifier among the multiple power amplifiers (321, 322, and 323);
identifying a temperature of the electronic device (101) by using a temperature sensor (370) while performing the first communication and the second communication;
in response to a situation in which the temperature of the electronic device (101) exceeds a first predetermined threshold temperature, releasing the second communication; and
switching a power amplifier which is to perform the first communication.

11. The method of claim 10, further comprising:
identifying a third power amplifier, among the multiple power amplifiers (321, 322, and 323), which is not used for the first communication and the second communication;
switching the first power amplifier (321) to the third power amplifier in response to the situation in which the temperature of the electronic device (101) exceeds the first predetermined threshold temperature; and
performing the first communication by using the switched third power amplifier.

12. The method of claim 10, wherein the switching of the power amplifier corresponding to the first communication comprises, in response to the release of the second communication, switching the first power amplifier (321) corresponding to the first communication to the second power amplifier, and
wherein the second power amplifier is supplied with relatively lower power than the first power amplifier (321) in a communication situation.

13. The method of claim 10, wherein the switching of the power amplifier corresponding to the first communication comprises, in response to the release of the second communication, switching the first power amplifier (321) corresponding to the first communication to the second power amplifier,
wherein the first power amplifier (321) supports the first communication based on frequency division duplexing (FDD), and
wherein the second power amplifier supports the second communication based on time division duplexing (TDD).

14. The method of claim 10, further comprising:
in response to the situation in which the temperature of the electronic device (101) exceeds the first predetermined threshold temperature, identifying a first transmission/reception ratio corresponding to the first communication and a second transmission/reception ratio corresponding to the second communication;
based on the first transmission/reception ratio and the second transmission/reception ratio, switching the first power amplifier (321) connected with the first communication to the second power amplifier in case that the first transmission/reception ratio is relatively higher than the second transmission/reception ratio; and
based on the first transmission/reception ratio and the second transmission/reception ratio, maintaining the first power amplifier (321) corresponding to the first communication in case that the first transmission/reception ratio is relatively lower than the second transmission/reception ratio.

15. A non-transitory computer-readable storage medium storing one or more programs for executing a method for performing communication by an electronic device (101),
wherein the one or more programs, when executed by a processor (120) of the electronic device (101), cause the electronic device to;
perform first communication by using a first power amplifier (321) among multiple power amplifiers (321, 322, and 323);
perform second communication by using a second power amplifier among the multiple power amplifiers (321, 322, and 323);
identify a temperature of the electronic device (101) by using a temperature sensor (370) while performing the first communication and the second communication;
in response to a situation in which the temperature of the electronic device (101) exceeds a first predetermined threshold temperature, release the second communication; and
switch a power amplifier which is to perform the first communication.
